# EUROPEAN PATENT APPLICATION

(11) **EP 3 376 241 A1**
(43) Date of publication of application: **19.09.2018**
(21) Application number: 16863455.8
(22) Date of filing: 19.08.2016
(51) Int. Cl.: G01R 31/00, H04L 12/10

(54) **NOISE LOCATION METHOD AND APPARATUS FOR REVERSE POWER FEED LINE**

(30) Priority: 13.11.2015 CN 201510779696
(71) Applicant: ZTE Corporation, Shenzhen, Guangdong 518057 (CN)
(72) Inventor: LU, Liuming, Shenzhen Guangdong 518057 (CN); YUAN, Liquan, Shenzhen Guangdong 518057 (CN); ZHANG, Weiliang, Shenzhen Guangdong 518057 (CN)
(74) Representative: Aipex B.V.
(86) International application number: PCT/CN2016/096054
(87) International publication number: WO 2017/080277

(57) **Abstract**

The present invention discloses a noise location method and apparatus for reverse power feed line. The method includes: detecting (201) a first noise situation of a subscriber line when there is no reverse power feed (RPF), detecting a second noise situation of the subscriber line when a power feed line of a power supply equipment (PSE) of a user terminal is connected to a power equipment (PE) and a power supply unit (PSU) of a distribution point unit (DPU) and the PSE supplies power, and detecting a third noise situation of the subscriber line when the PSE of the user terminal is disconnected from the PE and the PSU of the DPU and keeps the state of supplying power; and performing comparison on the first noise situation of the subscriber line, and the second noise situation of the subscriber line and/or the third noise situation of the subscriber line, and determining (202) whether a power supply noise emanates from the RPF and affects the subscriber line or not.

## Description

### TECHNICAL FIELD

The present application relates to, but is not limited to, the technical field of reverse power feed (RPF), and in particular, to a noise location method and apparatus for reverse power feed line.

### BACKGROUND

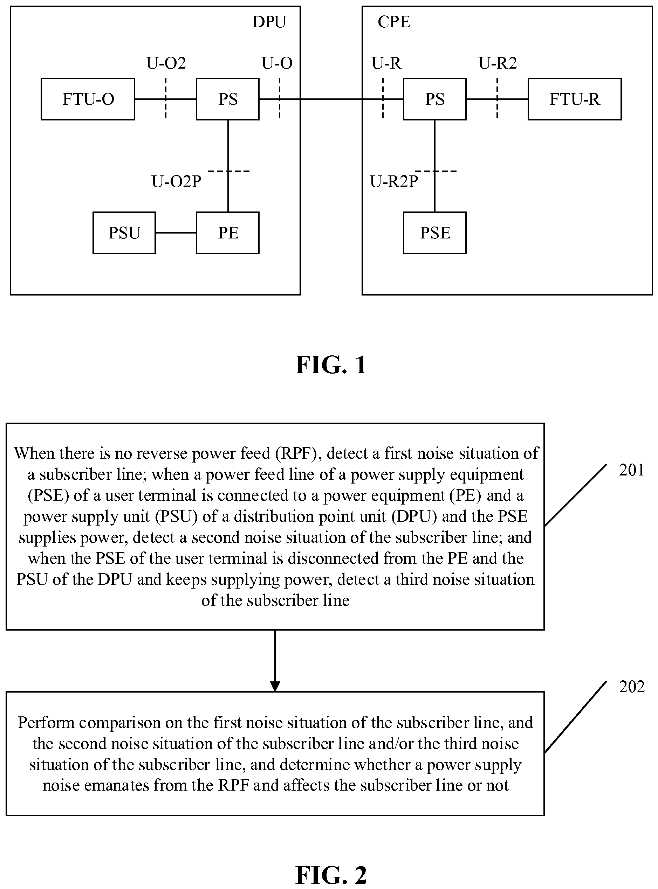

Fiber to the Distribution Point (FTTdp for short) is an important application scenario of a copper access system. As shown in FIG. 1, a Distribution Point Unit (DPU) is connected to a fiber access system upstream and is connected to a Customer Premise Equipment (CPE) downstream through the copper access system. The fiber access system includes a Passive Optical Network (PON) system and a Point to Point (P2P) fiber system. The copper access system includes a Fast Access to Subscriber Terminals (FAST) system and a Very High Speed Digital Subscriber Line 2 (VDSL2) system. Because a power supply environment in the FTTdp application scenario is limited, it is very difficult to supply power locally. Reverse Power Feed (RPF) is a function that necessarily supported by the copper access system. The power supply equipment (PSE) in a user terminal is used to supply power to the DPU. The PSE is either integrated with a customer premise equipment (CPE) on one device or a separate device. The distribution point unit may be connected to multiple subscriber lines downstream, and there is a need to perform reverse power feed on the DPU through one or more subscriber lines.

The copper access system supplies power to the DPU in the RPF manner, which causes an interference source to the subscriber lines while feeding the DPU. A power supply noise is one kind of electromagnetic interference. The conducted noise of the power supply noise has a frequency spectrum is approximately 10 kilohertz (kHz) to 30 megahertz (MHz), even up to 150 MHz. The power supply noise, especially a transient noise interference, is large in rising speed, short in duration, high in voltage amplitude, and strong in randomness, which easily causes serious interference to a microcomputer and a digital circuit.

It was found in a research that although a Power Splitter (PS) is used in an RPF system to filter a high-frequency signal of a power supply, failures can possibly occur the PSE and the PS. Moreover, since a vectoring technology between the lines is adopted in a G.fast system, the power supply noise introduced into a certain line affects normal operation of other lines as well.

### SUMMARY

The following is an overview of a subject matter detailed in the present application. This summary is not intended to limit a protection scope of the claims.

In order to analyze a noise situation of a reverse power feed line and obtain the location and cause of the noise emanating from an RPF system, a noise location method and apparatus for reverse power feed line is provided herein.

A noise location method for reverse power feed line is provided, which includes:
detecting a first noise situation of a subscriber line when there is no RPF, detecting a second noise situation of the subscriber line when a power feed line of a PSE of a user terminal is connected to a PE and a PSU of a DPU and the PSE supplies power, and detecting a third noise situation of the subscriber line when the PSE of the user terminal is disconnected from the PE and the PSU of the DPU and keeps the state of supplying power; and
performing comparison on the first noise situation of the subscriber line, and the second noise situation of the subscriber line and/or the third noise situation of the subscriber line, and determining whether a power supply noise emanates from the RPF and affects the subscriber line or not.

Optionally, the steps of performing comparison on the first noise situation of the subscriber line, and the second noise situation of the subscriber line and/or the third noise situation of the subscriber line and determining whether a power supply noise emanates from the RPF and affects the subscriber line or not include:
performing comparison on a communication quality parameter corresponding to the first noise situation of the subscriber line, and a communication quality parameter corresponding to the second noise situation of the subscriber line and/or a communication quality parameter corresponding to the third noise situation of the subscriber line, and analyzing whether the power supply noise emanates from the RPF and causes the communication quality parameter of the reverse power feed line to exceed a preset threshold or not.

Optionally, the method further includes: when the power supply noise emanates from the RPF and affects the subscriber line, determining a location and a cause of the power supply noise emanating from the RPF.

Optionally, the method further includes: when the power supply noise emanates from the RPF and affects the subscriber line, stopping supplying power through the RPF line corresponding to the power supply noise and/or setting the RPF line to a low-power state.

Optionally, the step of determining a location and a cause of the power supply noise emanating from the RPF includes: determining that a failure occurs in an RPF device of the DPU or an RPF device of the user terminal to cause the power supply noise to affect the subscriber line.

Optionally, the steps of detecting a first noise situation on a subscriber line when there is no RPF, detecting a second noise situation on the subscriber line when a power feed line of a PSE of a user terminal is connected to a PE and a PSU of a DPU and the PSE supplies power, and detecting a third noise situation on the subscriber line when the PSE of the user terminal is disconnected from the PE and the PSU of the DPU and keeps the state of supplying power include:

detecting a communication quality parameter of the subscriber line when there is no RPF, detecting a communication quality parameter of the subscriber line when the power feed line of the PSE of the user terminal is connected to the PE and the PSU of the DPU and the PSE supplies power, and detecting a communication quality parameter of the subscriber line when the PSE of the user terminal is disconnected from the PE and the PSU of the DPU and keeps the state of supplying power.

Optionally, the steps of detecting a communication quality parameter of the subscriber line when there is no RPF, detecting a communication quality parameter of the subscriber line when the power feed line of the PSE of the user terminal is connected to the PE and the PSU of the DPU and the PSE supplies power, and detecting a communication quality parameter of the subscriber line when the PSE of the user terminal is disconnected from the PE and the PSU of the DPU and keeps the state of supplying power includes:
when there is no RPF, detecting the communication quality parameter corresponding to the first noise situation of the subscriber line; when the communication quality parameter corresponding to the first noise situation of the subscriber line does not exceed a first preset parameter threshold, enabling the PSE to supply power and detecting the communication quality parameter corresponding to the third noise situation of the subscriber line; when the communication quality parameter corresponding to the third noise situation of the subscriber line does not exceed a third preset parameter threshold, connecting the power feed line of the PSE to the PE and the PSU of the DPU and detecting the communication quality parameter corresponding to the second noise situation of the subscriber line; or
connecting the power feed line of the PSE to the PE and the PSU of the DPU; detecting the communication quality parameter corresponding to the second noise situation of the subscriber line; when the communication quality parameter corresponding to the second noise situation of the subscriber line exceeds a second preset parameter threshold, disconnecting the PSE from the PE and the PSU of the DPU and detecting the communication quality parameter corresponding to the first noise situation of the subscriber line; when the communication quality parameter corresponding to the first noise situation of the subscriber line does not exceed the first preset parameter threshold, enabling the PSE to supply power and detecting the communication quality parameter corresponding to the third noise situation of the subscriber line.

Optionally, the communication quality parameter includes one or more of the followings: SNR, line attenuation, QLN, and ALN.

Optionally, the steps of performing comparison on the first noise situation of the subscriber line and the second noise situation of the subscriber line and/or the third noise situation of the subscriber line and the determining whether a power supply noise emanates from the RPF and affects the subscriber line include:
when it is detected that a communication quality parameter corresponding to the first noise situation of the subscriber line exceeds a first preset parameter threshold, determining that a failure occurs in the subscriber line when there is no RPF;
when it is detected that the communication quality parameter corresponding to the first noise situation of the subscriber line does not exceed the first preset parameter threshold and a communication quality parameter corresponding to the second noise situation of the subscriber line exceeds a second preset parameter threshold, determining that the power supply noise emanates from the RPF and affects the subscriber line;
when it is detected that the communication quality parameter corresponding to the first noise situation of the subscriber line does not exceed the first preset parameter threshold and a communication quality parameter corresponding to the third noise situation of the subscriber line exceeds a third preset parameter threshold, determining that the power supply noise emanates from the RPF and affects the subscriber line and determining that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold, and the communication quality parameter corresponding to the third noise situation does not exceed the third preset parameter threshold, determining that the power supply noise emanates from the RPF and affects the subscriber line and determining that a failure occurs in an RPF device of the DPU to cause the power supply noise.

Optionally, the method further includes: reporting the location and the cause of the power supply noise emanating from the RPF to a network management system.

A noise location apparatus for reverse power feed line is provided, which includes:
a power supply noise detection module, which is configured to detect a first noise situation on a subscriber line when there is no RPF, detect a second noise situation on the subscriber line when a power feed line of a PSE of a user terminal is connected to a PE and a PSU of a DPU and the PSE feeds, and detect a third noise situation on the subscriber line when the PSE of the user terminal is disconnected from the PE and the PSU of the DPU and keeps the state of supplying power; and
a power supply noise analysis module, which is configured to perform comparison on the first noise situation of the subscriber line, and the second noise situation of the subscriber line and/or the third noise situation of the subscriber line, and determine whether a power supply noise emanates from the RPF and affects the subscriber line or not.

Optionally, the power supply noise analysis module is configured to:
perform comparison on a communication quality parameter corresponding to the first noise situation of the subscriber line, and a communication quality parameter corresponding to the second noise situation of the subscriber line, and/or a communication quality parameter corresponding to the third noise situation of the subscriber line, and analyze whether the power supply noise emanates from the RPF and causes the communication quality parameter of the reverse power feed line to exceed a preset threshold or not.

Optionally, the power supply noise analysis module is further configured to: when the power supply noise emanates from the RPF and affects the subscriber line, determine a location and a cause of the power supply noise emanating from the RPF.

Optionally, the apparatus further includes a power supply noise processing module, which is configured to: when the power supply noise emanates from the RPF and affects the subscriber line, trigger a detection de-electrification function module to stop supplying power through an RPF line and/or set the RPF line to a low-power state; or trigger a power supply control interface module to control a power supply control module to stop supplying power through an RPF line and/or set the RPF line to a low-power state; or trigger a switch control module to stop supplying power through an RPF line and/or set the RPF line to a low-power state.

Optionally, the power supply noise analysis module is configured to determine that a failure occurs in an RPF device of the DPU or an RPF device of the user terminal to cause the power supply noise to affect the subscriber line.

Optionally, the power supply noise detection module is configured to:
detect a communication quality parameter of the subscriber line when there is no RPF, detect a communication quality parameter of the subscriber line when the power feed line of the PSE of the user terminal is connected to the PE and the PSU of the DPU and the PSE supplies power, and detect a communication quality parameter of the subscriber line when the PSE of the user terminal is disconnected from the PE and the PSU of the DPU and keeps the state of supplying power.

Optionally, the apparatus further includes a detection switch control module; the power supply noise detection module is configured to: when there is no RPF, detect a communication quality parameter corresponding to the first noise situation of the subscriber line; the power supply noise analysis module is configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to a detection electrification function module; the power supply noise detection module is further configured to detect a communication quality parameter corresponding to the third noise situation of the subscriber line; the power supply noise analysis module is further configured to: when the communication quality parameter corresponding to the third noise situation of the subscriber line exceeds a third preset parameter threshold, determine that a failure occurs in an RPF device of the user terminal to cause the power supply noise to affect the subscriber line; and when the communication quality parameter corresponding to the third noise situation of the subscriber line does not exceed the third preset parameter threshold, trigger the detection switch control module to disconnect the PSE from the detection electrification function module and connect the power feed line of the PSE to the PE and the PSU of the DPU; the power supply noise detection module is further configured to: detect a communication quality parameter corresponding to the second noise situation of the subscriber line; the power supply noise analysis module is further configured to: when the communication quality parameter corresponding to the second noise situation of the subscriber line exceeds a second preset parameter threshold, determine that a failure occurs in an RPF device of the DPU to cause the power supply noise to affect the subscriber line; or,
the detection switch control module is configured to connect the power feed line of the PSE to the PE and the PSU of the DPU; the power supply detection module is configured to detect a communication quality parameter corresponding to the second noise situation of the subscriber line; the power supply noise analysis module is configured to: when the communication quality parameter corresponding to the second noise situation of the subscriber line exceeds a second preset parameter threshold, trigger a detection de-electrification function module to stop supplying power through the power feed line or trigger a power supply control interface module to control a power supply control module to stop supplying power through the power feed line; the power supply noise detection module is further configured to detect a communication quality parameter corresponding to the first noise situation of the subscriber line; the power supply noise analysis module is further configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to the detection electrification function module; the power supply noise detection module is further configured to detect a communication quality parameter corresponding to the third noise situation of the subscriber line; and the power supply noise analysis module is further configured to: when a communication quality parameter corresponding to the third noise situation of the subscriber line exceeds a third preset parameter threshold, determine that a failure occurs in an RPF device of the user terminal to cause the power supply noise to affect the subscriber line, and when the communication quality parameter corresponding to the third noise situation of the subscriber line does not exceed the third preset parameter threshold, determine that a failure occurs in an RPF device of the DPU to cause the power supply noise to affect the subscriber line.

Optionally, the power supply noise analysis module is configured to:
when it is detected that the communication quality parameter corresponding to the first noise situation of the subscriber line exceeds a first preset parameter threshold, determine that a failure occurs in the subscriber line when there is no RPF;
when it is detected that the communication quality parameter corresponding to the first noise situation of the subscriber line does not exceed the first preset parameter threshold and a communication quality parameter corresponding to the second noise situation of the subscriber line exceeds a second preset parameter threshold, determine that the power supply noise emanates from the RPF and affects the subscriber line;
when it is detected that the communication quality parameter corresponding to the first noise situation of the subscriber line does not exceed the first preset parameter threshold and a communication quality parameter corresponding to the third noise situation of the subscriber line exceeds a third preset parameter threshold, determine that the power supply noise emanates from the RPF and affects the subscriber line and determine that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold and the communication quality parameter corresponding to the third noise situation of the subscriber line does not exceed the third preset parameter threshold, determine that the power supply noise emanates from the RPF and affects the subscriber line and determine that a failure occurs in an RPF device of the DPU to cause the power supply noise.

Optionally, the power supply noise processing module is further configured to report the location and the cause of the power supply noise emanating from the RPF to a network management system.

Optionally, the step in which the power supply noise processing module stops supplying power through the power feed line includes:
stopping supplying power through the RPF line and/or set of the RPF line to a low-power state.

A computer-readable storage medium storing computer-executable instructions is provided. The computer-executable instructions, when executed by a processor, implement the method described above.

According to the noise location method and apparatus for reverse power feed line provided by the embodiments of the present invention, a method and a processing mechanism for locating a power supply noise in a reverse power feed line. Noise situations of a subscriber line are detected respectively when there is no RPF (e.g., the PSE is disconnected from a power supply), when the power feed line of the PSE of the user terminal is connected to corresponding PE and PSU (e.g., corresponding to the line pair in which the PSE is located) of a DPU and the PSE supplies power, and when the PSE of the user terminal is disconnected from the corresponding PE and the PSU of the DPU but connected to a detection electrification function module to keep the PSE supplying power. The comprehensive comparison and analysis are performed to determine whether the RPF causes a serious power supply noise or not and obtain the location and cause of a failure of the RPF communication line, which includes to determine whether the noise emanates from the RPF device on local side or the RPF device on terminal side. Meanwhile, the embodiments of the present invention further provide a processing method and mechanism for the case in which the state of feeding of the PSE cannot be controlled due to the failure in the RPF device of the terminal side.

Other aspects will be understood upon reading and understanding accompanying drawings and detailed description.

### DESCRIPTION OF DRAWINGS

FIG. 1 is a schematic diagram showing an architecture of a communication system using reverse power feed in the related art;
FIG. 2 is a flow chart of a noise location method for reverse power feed line according to an embodiment of the present invention;
FIG. 3 is a structure diagram showing a noise location apparatus for reverse power feed line according to an embodiment of the present invention;
FIG. 4 is a structure diagram showing a terminal side with a power supply control module and a management interface according to an embodiment of the present invention;
FIG. 5 is a structure diagram showing a terminal side without a power supply control module according to an embodiment of the present invention;
FIG. 6 is a block diagram showing a terminal side with a power supply control module and a management interface according to an embodiment of the present invention;
FIG. 7 is a block diagram showing a terminal side without a power supply control module according to an embodiment of the present invention;
FIG. 8 is a schematic diagram of a process of exception handling of an RPF system of a terminal side according to an embodiment of the present invention;
FIG. 9 is a flow chart of the detection of a power supply noise initiated after a subscriber line establishes a link to start communication and starts reverse power feed according to an embodiment of the present invention; and
FIG. 10 is a flow chart of the detection of a power supply noise initiated before a subscriber line establishes a link to start communication and after starts reverse power feed according to an embodiment of the present invention.

### DETAILED DESCRIPTION OF EMBODIMENT

The following describes embodiments of the present invention with reference to accompanying drawings. It is to be noted that the embodiments in the present application and features in the embodiments may be combined with each other arbitrarily without conflict.

As shown in FIG. 2, an embodiment of the present invention provides a noise location method for reverse power feed line. The method includes the steps described below.

In step 201, when there is no reverse power feed (RPF), a first noise situation of a subscriber line is detected; when a power feed line of a power supply equipment (PSE) of a user terminal is connected to a power equipment (PE) and a power supply unit (PSU) of a distribution point unit (DPU) and the PSE supplies power, a second noise situation of the subscriber line is detected; and when the PSE of the user terminal is disconnected from the PE and the PSU of the DPU and keeps the state of supplying power, a third noise situation of the subscriber line is detected.

In step 202, comparison on the first noise situation of the subscriber line, and the second noise situation of the subscriber line and/or the third noise situation of the subscriber line is performed, and it is determined whether a power supply noise emanates from the RPF and affects the subscriber line or not.

That the comparison on the first noise situation of the subscriber line, and the second noise situation of the subscriber line and/or the third noise situation of the subscriber line is performed and it is determined whether the power supply noise emanates from the RPF and affects the subscriber line or not includes one of the followings:
according to the first noise situation of the subscriber line and the second noise situation of the subscriber line, it is determined whether the power supply noise emanates from the RPF and affects the subscriber line or not;
according to the first noise situation of the subscriber line and the third noise situation of the subscriber line, it is determined whether the power supply noise emanates from the RPF and affects the subscriber line or not; and
according to the first noise situation of the subscriber line, the second noise situation of the subscriber line and the third noise situation of the subscriber line, it is determined whether the power supply noise emanates from the and RPF affects the subscriber line or not.

That the comparison on the first noise situation of the subscriber line, and the second noise situation of the subscriber line and/or the third noise situation of the subscriber line is performed, and it is determined whether a power supply noise emanating from the RPF affects the subscriber line or not includes:
comparison on a communication quality parameter corresponding to the first noise situation of the subscriber line, and a communication quality parameter corresponding to the second noise situation of the subscriber line, and/or a communication quality parameter corresponding to the third noise situation of the subscriber line is performed, and it is analyzed whether a power supply noise emanates from the RPF and causes the communication quality parameter of the reverse power feed line to exceed a preset threshold or not.

When the power supply noise emanates from the RPF and affects the subscriber line, the location and cause of the power supply noise emanating from the RPF are determined.

When the power supply noise is severe enough to affect the subscriber line, the location and cause of the power supply noise emanating from the RPF system may be determined.

When the power supply noise emanates from the RPF and affects the subscriber line, the power supply through the corresponding RPF line is stopped and/or the RPF line is set to a low-power state.

That the location and cause of the power supply noise emanating from the RPF are determined includes: it is determined that a failure occurs in an RPF device of the DPU or an RPF device of the user terminal to cause the power supply noise to affect the subscriber line.

That a first noise situation of a subscriber line is detected when there is no RPF, a second noise situation of the subscriber line is detected when a power feed line of a PSE of a user terminal is connected to a PE and a PSU of a DPU and the PSE supplies power, and a third noise situation of the subscriber line is detected when the PSE of the user terminal is disconnected from the PE and the PSU of the DPU and keeps the state of supplying power include:

the communication quality parameter of the subscriber line is detected respectively when there is no RPF, when the power feed line of the PSE of the user terminal is connected to the PE and the PSU of the DPU and the PSE supplies power, and when the PSE of the user terminal is disconnected from the PE and the PSU of the DPU and keeps the state of supplying power.

That the communication quality parameter of the subscriber line is detected respectively when there is no RPF, when the power feed line of the PSE of the user terminal is connected to the PE and the PSU of the DPU and the PSE supplies power, and when the PSE of the user terminal is disconnected from the PE and the PSU of the DPU and keeps the state of supplying power includes:
when there is no RPF, the communication quality parameter corresponding to the first noise situation of the subscriber line is detected; when the communication quality parameter corresponding to the first noise situation of the subscriber line does not exceed a first preset parameter threshold, the PSE is enabled to supply power and the communication quality parameter corresponding to the third noise situation of the subscriber line is detected; when the communication quality parameter corresponding to the third noise situation of the subscriber line does not exceed a third preset parameter threshold, the power feed line of the PSE is connected to the PE and the PSU of the DPU and the communication quality parameter corresponding to the second noise situation of the subscriber line is detected;
or, the power feed line of the PSE is connected to the PE and the PSU of the DPU; the communication quality parameter corresponding to the second noise situation of the subscriber line is detected; when the communication quality parameter corresponding to the second noise situation of the subscriber line exceeds a second preset parameter threshold, the PSE is disconnected from the PE and the PSU of the DPU and the communication quality parameter corresponding to the first noise situation of the subscriber line is detected; when the communication quality parameter corresponding to the first noise situation of the subscriber line does not exceed the first preset parameter threshold, the PSE is enabled to supply power and the communication quality parameter corresponding to the third noise situation of the subscriber line is detected.

The communication quality parameter includes one or more of the followings: a signal-to-noise ratio SNR, a line attenuation value, a quiet line noise (QLN), and an active line noise (ALN).

That the comparison on the first noise situation of the subscriber line, and the second noise situation of the subscriber line and/or the third noise situation of the subscriber line is performed, and it is determined whether a power supply noise emanates from the RPF and affects the subscriber line or not include:
when it is detected that the communication quality parameter corresponding to the first noise situation of the subscriber line exceeds a first preset parameter threshold, it is determined that a failure occurs in the subscriber line when there is no RPF;
when it is detected that the communication quality parameter corresponding to the first noise situation of the subscriber line does not exceed the first preset parameter threshold and the communication quality parameter corresponding to the second noise situation of the subscriber line exceeds a second preset parameter threshold, it is determined that the power supply noise emanates from the RPF and affects the subscriber line;
when it is detected that the communication quality parameter corresponding to the first noise situation of the subscriber line does not exceed the first preset parameter threshold and the communication quality parameter corresponding to the third noise situation of the subscriber line exceeds the third preset parameter threshold, it is determined that the power supply noise emanates from the RPF and affects the subscriber line and it is determined that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold, and the communication quality parameter corresponding to the third noise situation does not exceed a third preset parameter threshold, it is determined that the power supply noise emanates from the RPF and affects the subscriber line and it is determined that a failure occurs in an RPF device of the DPU to cause the power supply noise.

The method may further include that the location and cause of the noise emanating from the RPF are reported to a network management system.

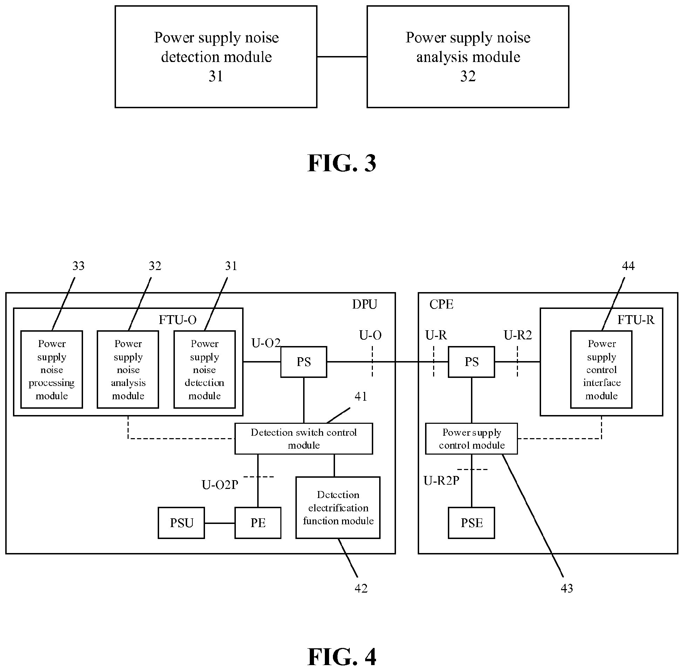

As shown in FIG. 3, an embodiment of the present invention further provides a noise location apparatus for reverse power feed line, which includes:
a power supply noise detection module 31, which is configured to detect a first noise situation on a subscriber line when there is no RPF, detect a second noise situation on the subscriber line when a power feed line of a PSE of a user terminal is connected to a PE and a PSU of a DPU and the PSE feeds, and detect a third noise situation on the subscriber line when the PSE of the user terminal is disconnected from the PE and the PSU of the DPU and keeps the state of supplying power; and
a power supply noise analysis module 32, which is configured to perform comparison on the first noise situation of the subscriber line, and the second noise situation of the subscriber line and/or the third noise situation of the subscriber line, and determine whether a power supply noise emanates from the RPF and affects the subscriber line or not.

The power supply noise analysis module is configured to:
perform comparison on a communication quality parameter corresponding to the first noise situation of the subscriber line, and a communication quality parameter corresponding to the second noise situation of the subscriber line, and/or a communication quality parameter corresponding to the third noise situation of the subscriber line, and analyze whether the power supply noise emanates from the RPF and causes the communication quality parameter of the reverse power feed line to exceed a preset threshold or not.

The power supply noise analysis module is further configured to: when the power supply noise emanates from the RPF and affects the subscriber line, determine a location and a cause of the power supply noise emanating from the RPF.

The apparatus further includes a power supply noise processing module, which is configured to: when the power supply noise emanates from the RPF and affects the subscriber line, trigger a detection de-electrification function module to stop supplying power through an RPF line and/or set the RPF line to a low-power state; or trigger a power supply control interface module to control a power supply control module to stop supplying power through an RPF line and/or set the RPF line to a low-power state; or trigger a switch control module to stop supplying power through an RPF line and/or set the RPF line to a low-power state.

That the power supply noise analysis module determines a location and a cause of the power supply noise emanating from the RPF includes: the power supply noise analysis module determines that a failure occurs in an RPF device of the DPU or an RPF device of the user terminal to cause the power supply noise to affect the subscriber line.

The power supply noise detection module 31 is configured to:
detect a communication quality parameter of the subscriber line when there is no RPF, detect a communication quality parameter of the subscriber line when the power feed line of the PSE of the user terminal is connected to the PE and the PSU of the DPU and the PSE supplies power, and detect a communication quality parameter of the subscriber line when the PSE of the user terminal is disconnected from the PE and the PSU of the DPU and keeps the state of supplying power.

The power supply noise detection module is configured to: when there is no RPF, detect a communication quality parameter corresponding to the first noise situation of the subscriber line; the power supply noise analysis module is configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to a detection electrification function module; the power supply noise detection module is further configured to detect a communication quality parameter corresponding to the third noise situation of the subscriber line; the power supply noise analysis module is further configured to: when the communication quality parameter corresponding to the third noise situation of the subscriber line exceeds a third preset parameter threshold, determine that a failure occurs in an RPF device of the user terminal to cause the power supply noise to affect the subscriber line; and when the communication quality parameter corresponding to the third noise situation of the subscriber line does not exceed the third preset parameter threshold, trigger the detection switch control module to disconnect the PSE from the detection electrification function module and connect the power feed line of the PSE to the PE and the PSU of the DPU; the power supply noise detection module is further configured to: detect a communication quality parameter corresponding to the second noise situation of the subscriber line; the power supply noise analysis module is further configured to: when the communication quality parameter corresponding to the second noise situation of the subscriber line exceeds a second preset parameter threshold, determine that a failure occurs in an RPF device of the DPU to cause the power supply noise to affect the subscriber line; or
a detection switch control module is configured to connect the power feed line of the PSE to the PE and the PSU of the DPU; the power supply detection module is configured to detect a communication quality parameter corresponding to the second noise situation of the subscriber line; the power supply noise analysis module is configured to: when the communication quality parameter corresponding to the second noise situation of the subscriber line exceeds a second preset parameter threshold, trigger a detection de-electrification function module to stop supplying power through the power feed line or trigger a power supply control interface module to control a power supply control module to stop supplying power through the power feed line; the power supply noise detection module is further configured to detect a communication quality parameter corresponding to the first noise situation of the subscriber line; the power supply noise analysis module is further configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to the detection electrification function module; the power supply noise detection module is further configured to detect a communication quality parameter corresponding to the third noise situation of the subscriber line; and the power supply noise analysis module is further configured to: when a communication quality parameter corresponding to the third noise situation of the subscriber line exceeds a third preset parameter threshold, determine that a failure occurs in an RPF device of the user terminal to cause the power supply noise to affect the subscriber line, and when the communication quality parameter corresponding to the third noise situation of the subscriber line does not exceed the third preset parameter threshold, determine that a failure occurs in an RPF device of the DPU to cause the power supply noise to affect the subscriber line.

The power supply noise analysis module is configured to:
when it is detected that the communication quality parameter corresponding to the first noise situation of the subscriber line exceeds a first preset parameter threshold, determine that a failure occurs in the subscriber line when there is no RPF;
when it is detected that the communication quality parameter corresponding to the first noise situation of the subscriber line does not exceed the first preset parameter threshold and a communication quality parameter corresponding to the second noise situation of the subscriber line exceeds a second preset parameter threshold, determine that the power supply noise emanates from the RPF and affects the subscriber line;
when it is detected that the communication quality parameter corresponding to the first noise situation of the subscriber line does not exceed the first preset parameter threshold and a communication quality parameter corresponding to the third noise situation of the subscriber line exceeds a third preset parameter threshold, determine that the power supply noise emanates from the RPF and affects the subscriber line and determine that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold and the communication quality parameter corresponding to the third noise situation of the subscriber line does not exceed the third preset parameter threshold, determine that the power supply noise emanates from the RPF and affects the subscriber line and determine that a failure occurs in an RPF device of the DPU to cause the power supply noise.

The power supply noise processing module is further configured to report the location and the cause of the power supply noise emanating from the RPF to a network management system.

### Embodiment 1

According to whether a terminal side provides a power supply control module and a management interface to a local side, different mechanisms and architectures may be employed to implement the system.

In a framework of a power supply noise location system in which the terminal side provides the power supply control module and the management interface to the local side, the local side may control a power supply state (e.g., turning on or off the power supply) by means of the power supply control management interface provided by the terminal side in a course of locating power supply noise, as shown in FIG. 4.

The local side includes a detection switch control module 41, a detection electrification function module 42, a power supply noise detection module 31, a power supply noise analysis module 32, and a power supply noise processing module 33.

The terminal side includes a power supply control module 43 and a power supply control interface module 44.

The power supply noise analysis module 32 may determine whether RPF causes a serious power supply noise or not and obtains the location and the cause of a failure of a RPF communication line (including to determine whether the power supply noise emanates from a RPF device of the local side or a RPF device of the terminal side) according to noise situations of a subscriber line which are detected respectively when there is no RPF, when a power feed line of a PSE of the terminal is connected to a PSU of the local side and the PSE supplies power, and when the PSE of the terminal is connected to the detection electrification function module and supplies power (i.e., a power supply noise on the terminal side is detected) and on which comprehensive comparison and analysis are performed.

The power supply noise processing module 33 receives an analysis result of the power supply noise analysis module of the local side; performs a corresponding action according to a strategy, for example, stops the power supply through the power feed line, starts the detection of the power supply noise of the terminal side, and sets the power feed line to a low-power state; and reports the cause of the failure to a superior network management system.

The power supply noise detection module 31 detects the noise situations of a subscriber line which are detected respectively when there is no RPF, when the power feed line of a PSE of the terminal is connected to the PSU of the local side and the PSE supplies power, and when the PSE of the terminal is connected to the detection electrification function module and supplies power (i.e., a power supply noise on the terminal side is detected); moreover, according to the situation of the subscriber line required to be detected in the RPF state, determines to detect which one of the first noise situation of the subscriber line, the second noise situation of the subscriber line and the third noise situation of the subscriber line; and employs a management entity to control the states of the detection switch control module, a line switch control module and the power supply control module.

The detection switch control module 41 controls a connection state of the PS of the local side to the PSU or the detection electrification function module according to whether a need of detecting the power supply noise of the terminal side exists; by default, connects the PS of the local side to the PSU but disconnects the PS from the detection electrification function module to ensure normal operation of the RPF; and when receiving a detection control instruction, switches the PS to be connected to the electrification function module and disconnected from the PSU.

The detection electrification function module 42 detects the power supply noise of the terminal side, meets a circuit requirement allowing the RPF by the PSE of terminal side, and keeps the RPF, thereby facilitating the detection of the noise of the communication line in the power supply state. This detection electrification function module is a logical function module that may be an independent entity or may be integrated in other devices.

The power supply control interface module 44 receives a power supply control instruction from the local side and controls the state of the power supply control module.

The power supply control module 43 controls the PS and the PSE of the terminal side to be connected or disconnected. By default, the PS is connected to the PSE.

### Embodiment 2

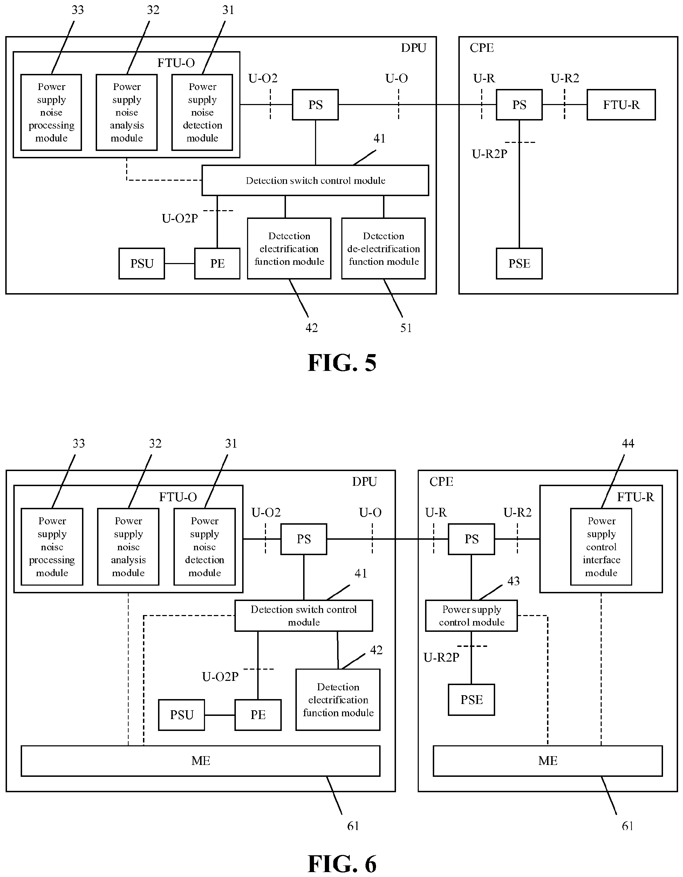

An architecture of a power supply noise location system in which a terminal side does not provide a power supply control module and a management interface to a local side is as shown in FIG. 5. The modules relevant to the location of a power supply noise are provided only on the local side, including a detection switch control module 41, a detection electrification function module 42, a power supply noise detection module 31, a power supply noise analysis module 32, a power supply noise processing module 33, and a detection de-electrification function module 51. The power supply state of the terminal side is controlled by the detection de-electrification function module.

Functions of the function modules involved in the power supply noise location system are the same as those of the embodiment 1.

The detection de-electrification function module 51 provides a circuit function that does not allow the electrification of a PSE so as to implement a function of remotely stopping the electrification of the PSE of the terminal side; and provides another method of stopping the electrification of the PSE when the terminal side does not have a power supply control module. This module is a logic function module that may be a separate entity or may be integrated in other devices.

### Embodiment 3

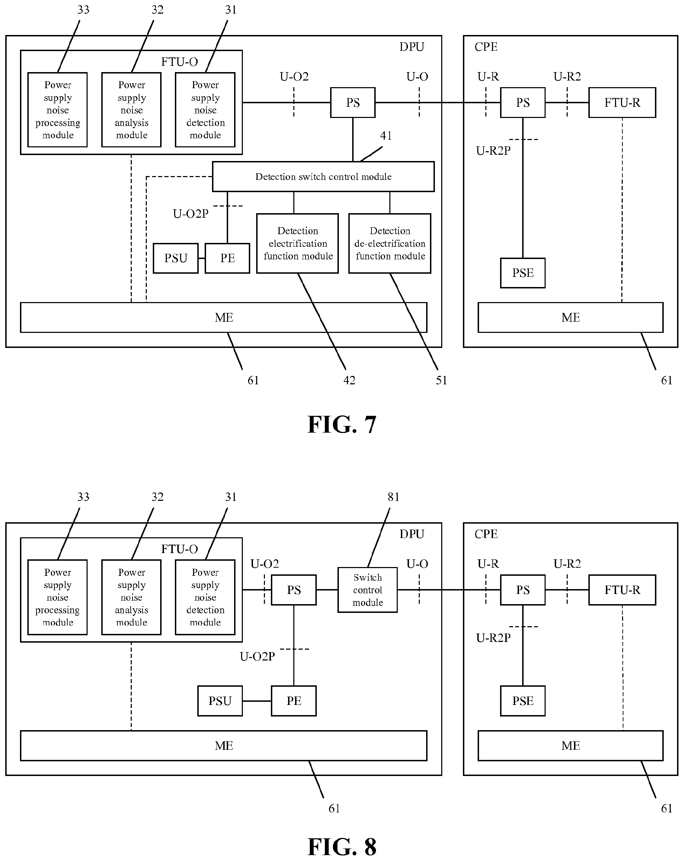

In an implementation process, a power supply noise location system may use a management entity (ME) to implement transmission of control information and detection information. An implementation architecture in which a terminal side has a power supply control module and a management interface is shown in FIG. 6, where the control information from the local side for controlling a RPF power supply of the terminal side may be transmitted through a communication channel (e.g., a G.fast or VDSL2 channel) of a subscriber line. An implementation architecture in which the terminal side does not have the power supply control module and the management interface is shown in FIG. 7.

### Embodiment 4

When an RPF device of a terminal side fails and is unable to control a power supply state of the PSE of the terminal side, the subscriber line of the terminal side is physically disconnected at a local side. An exception handling mechanism of a RPF system of the terminal side is as shown in FIG. 8. A line switch control module 81 is added on the local side, which has a function of controlling the subscriber line to be physically connected to or disconnected from a DPU device (by default, the subscriber line is connected to the DPU device); and when an exception occurs in the RPF system of the terminal side and the power supply by the PSE cannot be stopped under control, the local side may use the line switch control module to physically disconnect the subscriber line. In an actual implementation process, the line switch control module may be controlled through a management channel provided by a management entity.

### Embodiment 5

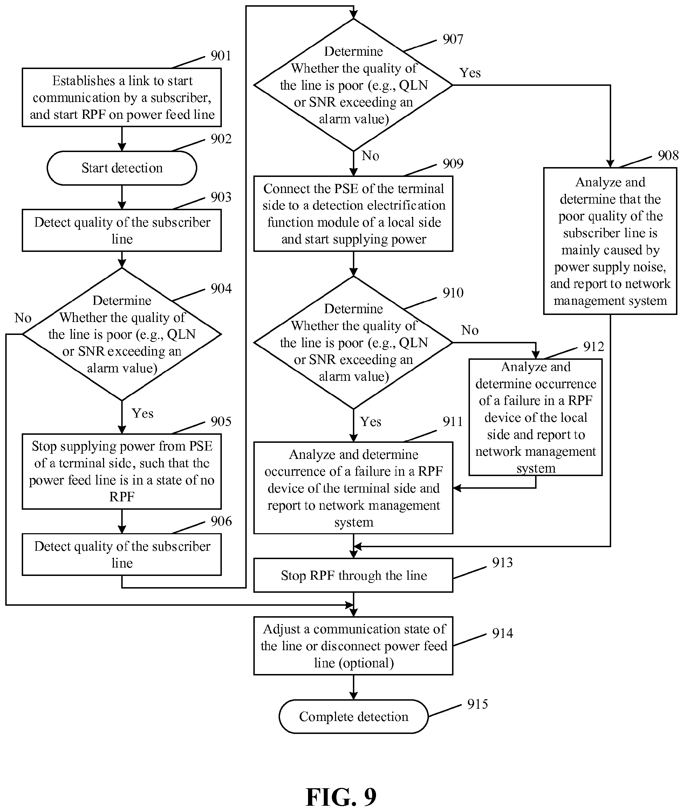

The power supply noise may be detected when a subscriber line starts communication or RPF is started. The process of detecting the power supply noise is performed according to a communication state of the subscriber line and an RPF situation. FIG. 9 is the process of detecting the power supply noise initiated after a subscriber line establishes a link to start communication and the RPF is started.

In step 901, the subscriber line establishes a link to start communication and an RPF is started.

In step 902, detection is started, and the detection process is as follows.

In step 903, a power supply noise detection module connects a power feed line of the PSE to a PE and a PSU of a DPU, and the power supply noise detection module detects a communication quality parameter corresponding to a second noise situation of the subscriber line.

In step 904, it is determined whether the communication quality parameter corresponding to the second noise situation of the subscriber line exceeds a second preset parameter threshold or not; if the communication quality parameter corresponding to the second noise situation exceeds the second preset parameter threshold, a step 905 is performed; otherwise, a step 915 is performed and the process ends.

In step 905, the power supply noise analysis module triggers a detection de-electrification function module to stop supplying power through the power feed line or triggers a power supply control interface module to control a power supply control module to stop supplying power through the power feed line.

In step 906, the power supply noise detection module detects a communication quality parameter corresponding to a first noise situation of the subscriber line.

In step 907, it is determined whether the communication quality parameter corresponding to the first noise situation of the subscriber line exceeds a first preset parameter threshold or not; if the communication quality parameter corresponding to the first noise situation exceeds the first preset parameter threshold, a step 908 is performed; otherwise, a step 909 is performed.

In step 908, the power supply noise analysis module determines that a failure occurs in the subscriber line when there is no RPF.

In step 909, the communication quality parameter corresponding to the first noise situation of the subscriber line does not exceed the first preset parameter threshold, the power supply noise analysis module triggers a detection switch control module to turn on the power supply through a PSE, so as to connect the PSE to a detection electrification function module.

In step 910, the power supply noise detection module detects a communication quality parameter corresponding to a third noise situation of the subscriber line. It is determined whether the communication quality parameter corresponding to the third noise situation of the subscriber line exceeds a third preset parameter threshold or not; if the communication quality parameter corresponding to the third noise situation exceeds the third preset parameter threshold, a step 911 is performed; otherwise, a step 912 is performed.

In step 911, a power supply noise analysis module determines that a failure occurs in an RPF device of the user terminal to cause the power supply noise to affect the subscriber line; and a step 913 is performed.

In step 912, the communication quality parameter corresponding to the third noise situation of the subscriber line does not exceed the third preset parameter threshold, and the power supply noise analysis module determines that a failure occurs in the RPF device of the DPU to cause the power supply noise to affect the subscriber line.

In step 913, when a power supply noise emanates from the RPF and affects the subscriber line, a power supply noise processing module triggers a detection de-electrification function module to stop the power supply through the power feed line, or triggers the power supply control interface module to control the power supply control module to stop the power supply through the power feed line.

In step 914, a communication state of the subscriber line is adjusted or the power feed line is disconnected. This step is an optional step.

In step 915, the detection process ends.

### Embodiment 6

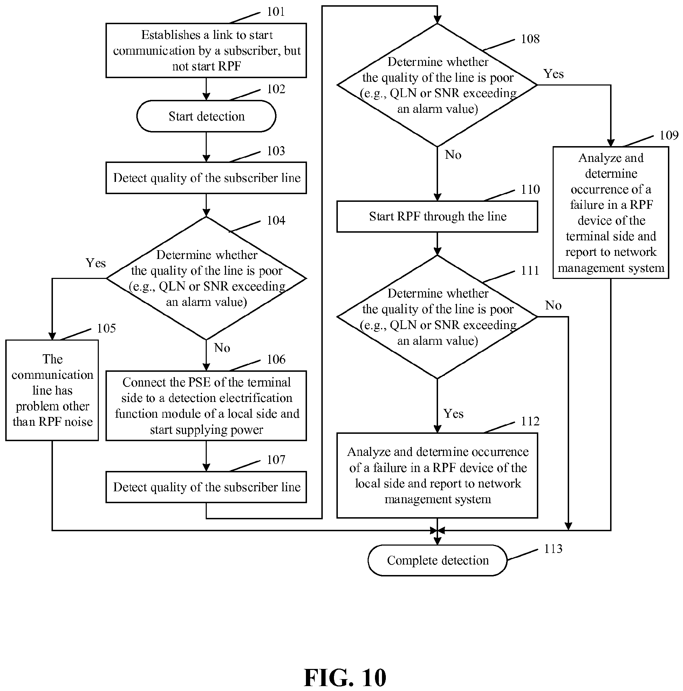

The power supply noise may be detected in real time during communication through a subscriber line and RPF, and a process of detecting power supply noise is performed according to a communication state of the subscriber line and a RPF situation. FIG. 10 is the process of detecting the power supply noise before a subscriber line establishes a link to start communication and RPF is started.

In step 101, the subscriber line establishes the link to start communication, and RPF is not started.

In step 102, detection is started, and the detection process is as follows.

In step 102, when there is no RPF, a power supply noise detection module detects a communication quality parameter corresponding to a first noise situation of the subscriber line.

In step 104, it is determined whether the communication quality parameter corresponding to the first noise situation of the subscriber line exceeds a first preset parameter threshold or not; if the communication quality parameter corresponding to the first noise situation exceeds the first preset parameter threshold, a step 105 is performed; otherwise, a step 106 is performed.

In step 105, a power supply noise analysis module determines that a failure occurs in the subscriber line when there is no RPF, a step 113 is performed, and the process ends.

In step 106, the communication quality parameter corresponding to the first noise situation of the subscriber line does not exceed the first preset parameter threshold, the power supply noise analysis module triggers a detection switch control module, and starts power supply through a PSE so as to connect the PSE to a detection electrification function module.

In step 107, the power supply noise detection module detects a communication quality parameter corresponding to a third noise situation of the subscriber line.

In step 108, it is determined whether the communication quality parameter corresponding to the third noise situation of the subscriber line exceeds a third preset parameter threshold or not; if the communication quality parameter corresponding to the third noise situation of the subscriber line exceeds the third preset parameter threshold, a step 109 is performed; otherwise, a step 110 is performed.

In step 109, the power supply noise analysis module determines that a failure occurs in a RPF device of the user terminal to cause a power supply noise to affect the subscriber line, a step 113 is performed, and the process ends.

In step 110, the communication quality parameter corresponding to the third noise situation of the subscriber line does not exceed a third preset parameter threshold, the power supply noise analysis module triggers a detection switch control module to disconnect the PSE from a detection electrification function module and connect a power feed line of the PSE to a PE and a PSU of a DPU.

In step 111, the power supply noise detection module detects a communication quality parameter corresponding to a second noise situation of the subscriber line, it is determined whether the communication quality parameter corresponding to the second noise situation of the subscriber line exceeds a second preset parameter threshold or not; if the communication quality parameter corresponding to the second noise situation exceeds the second preset parameter threshold, a step 112 is performed; otherwise, a step 113 is performed and the process ends.

In step 112, the power supply noise analysis module determines that a failure occurs in a RPF device of the DPU to cause the power supply noise to affect the subscriber line.

In step 113, the detection process ends.

An embodiment of the present invention further provides a computer-readable storage medium storing computer-executable instructions, and the computer-executable instructions, when executed by a processor, implement the noise location method for reverse power feed line.

While the embodiments disclosed in the present application are as described above, their contents are merely the embodiments for facilitating the understanding of the technical solution of the present application and are not intended to limit the present application. Any person skilled in the art to which the present application belongs may make any modifications and changes in the form and details of the implementation without departing from the core technical solution disclosed in the present application, but a protective scope defined by the present application shall still be subject to the scope defined in the appended claims.

### INDUSTRIAL APPLICABILITY

According to the noise location method and apparatus for reverse power feed line provided by the embodiments of the present invention, a method and a processing mechanism for locating a power supply noise in a reverse power feed line. Noise situations of a subscriber line are detected respectively when there is no RPF (e.g., the PSE is disconnected from a power supply), when the power feed line of the PSE of the user terminal is connected to corresponding PE and PSU (e.g., corresponding to the line pair in which the PSE is located) of a DPU and the PSE supplies power, and when the PSE of the user terminal is disconnected from the corresponding PE and the PSU of the DPU but connected to a detection electrification function module to keep the PSE supplying power. The comprehensive comparison and analysis are performed to determine whether the RPF causes a serious power supply noise or not and obtain the location and cause of a failure of the RPF communication line, which includes to determine whether the noise emanates from the RPF device on local side or the RPF device on terminal side.

## Claims

1. A noise location method for reverse power feed line, comprising:
detecting a first noise situation of a subscriber line when there is no reverse power feed (RPF), detecting a second noise situation of the subscriber line when a power feed line of a power supply equipment (PSE) of a user terminal is connected to a power equipment (PE) and a power supply unit (PSU) of a distribution point unit (DPU) and the PSE supplies power, and detecting a third noise situation of the subscriber line when the PSE of the user terminal is disconnected from the PE and the PSU of the DPU and keeps a state of supplying power; and
performing comparison on the first noise situation of the subscriber line, and the second noise situation of the subscriber line and/or the third noise situation of the subscriber line, and determining whether a power supply noise emanates from the RPF and affects the subscriber line or not.

2. The method according to claim 1, wherein the steps of performing comparison on the first noise situation of the subscriber line, and the second noise situation of the subscriber line and/or the third noise situation of the subscriber line and determining whether a power supply noise emanates from the RPF and affects the subscriber line or not comprise:
performing comparison on a communication quality parameter corresponding to the first noise situation of the subscriber line, and a communication quality parameter corresponding to the second noise situation of the subscriber line and/or a communication quality parameter corresponding to the third noise situation of the subscriber line, and analyzing whether the power supply noise emanates from the RPF and causes the communication quality parameter of the reverse power feed line to exceed a preset threshold or not.

3. The method according to claim 1 or 2, further comprising: when the power supply noise emanates from the RPF and affects the subscriber line, determining a location and a cause of the power supply noise emanating from the RPF.

4. The method according to claim 1, further comprising: when the power supply noise emanates from the RPF and affects the subscriber line, stopping supplying power through the RPF line corresponding to the power supply noise and/or setting the RPF line to a low-power state.

5. The method according to claim 3, wherein the step of determining a location and a cause of the power supply noise emanating from the RPF comprises: determining that a failure occurs in an RPF device of the DPU or an RPF device of the user terminal to cause the power supply noise to affect the subscriber line.

6. The method according to claim 1 or 2, wherein the steps of detecting a first noise situation on a subscriber line when there is no RPF, detecting a second noise situation on the subscriber line when a power feed line of a PSE of a user terminal is connected to a PE and a PSU of a DPU and the PSE supplies power, and detecting a third noise situation on the subscriber line when the PSE of the user terminal is disconnected from the PE and the PSU of the DPU and keeps the state of supplying power comprise:
detecting a communication quality parameter of the subscriber line when there is no RPF, detecting a communication quality parameter of the subscriber line when the power feed line of the PSE of the user terminal is connected to the PE and the PSU of the DPU and the PSE supplies power, and detecting a communication quality parameter of the subscriber line when the PSE of the user terminal is disconnected from the PE and the PSU of the DPU and keeps the state of supplying power.

7. The method according to claim 6, wherein the steps of detecting a communication quality parameter of the subscriber line when there is no RPF, detecting a communication quality parameter of the subscriber line when the power feed line of the PSE of the user terminal is connected to the PE and the PSU of the DPU and the PSE supplies power, and detecting a communication quality parameter of the subscriber line when the PSE of the user terminal is disconnected from the PE and the PSU of the DPU and keeps the state of supplying power comprise:
when there is no RPF, detecting the communication quality parameter corresponding to the first noise situation of the subscriber line; when the communication quality parameter corresponding to the first noise situation of the subscriber line does not exceed a first preset parameter threshold, enabling the PSE to supply power and detecting the communication quality parameter corresponding to the third noise situation of the subscriber line; when the communication quality parameter corresponding to the third noise situation of the subscriber line does not exceed a third preset parameter threshold, connecting the power feed line of the PSE to the PE and the PSU of the DPU and detecting the communication quality parameter corresponding to the second noise situation of the subscriber line; or
connecting the power feed line of the PSE to the PE and the PSU of the DPU; detecting the communication quality parameter corresponding to the second noise situation of the subscriber line; when the communication quality parameter corresponding to the second noise situation of the subscriber line exceeds a second preset parameter threshold, disconnecting the PSE from the PE and the PSU of the DPU and detecting the communication quality parameter corresponding to the first noise situation of the subscriber line; when the communication quality parameter corresponding to the first noise situation of the subscriber line does not exceed the first preset parameter threshold, enabling the PSE to supply power and detecting the communication quality parameter corresponding to the third noise situation of the subscriber line.

8. The method according to claim 2 or 6, wherein the communication quality parameter comprises one or more of the followings: a signal noise ratio (SNR), a line attenuation, a quiet line noise (QLN), and an active line noise (ALN).

9. The method according to claim 3, wherein the steps of performing comparison on the first noise situation of the subscriber line and the second noise situation of the subscriber line and/or the third noise situation of the subscriber line and the determining whether a power supply noise emanates from the RPF and affects the subscriber line comprise:
when it is detected that a communication quality parameter corresponding to the first noise situation of the subscriber line exceeds a first preset parameter threshold, determining that a failure occurs in the subscriber line when there is no RPF;
when it is detected that the communication quality parameter corresponding to the first noise situation of the subscriber line does not exceed the first preset parameter threshold and a communication quality parameter corresponding to the second noise situation of the subscriber line exceeds a second preset parameter threshold, determining that the power supply noise emanates from the RPF and affects the subscriber line;
when it is detected that the communication quality parameter corresponding to the first noise situation of the subscriber line does not exceed the first preset parameter threshold and a communication quality parameter corresponding to the third noise situation of the subscriber line exceeds a third preset parameter threshold, determining that the power supply noise emanates from the RPF and affects the subscriber line and determining that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold, and the communication quality parameter corresponding to the third noise situation does not exceed the third preset parameter threshold, determining that the power supply noise emanates from the RPF and affects the subscriber line and determining that a failure occurs in an RPF device of the DPU to cause the power supply noise.

10. The method according to claim 3, further comprising: reporting the location and the cause of the power supply noise emanating from the RPF to a network management system.

11. A noise location apparatus for reverse power feed line, comprising:
a power supply noise detection module, which is configured to detect a first noise situation on a subscriber line when there is no reverse power feed (RPF), detect a second noise situation on the subscriber line when a power feed line of a power supply equipment (PSE) of a user terminal is connected to a power equipment (PE) and a power supply unit (PSU) of a distribution point unit (DPU) and the PSE feeds, and detect a third noise situation on the subscriber line when the PSE of the user terminal is disconnected from the PE and the PSU of the DPU and keeps a state of supplying power; and
a power supply noise analysis module, which is configured to perform comparison on the first noise situation of the subscriber line, and the second noise situation of the subscriber line and/or the third noise situation of the subscriber line, and determine whether a power supply noise emanates from the RPF and affects the subscriber line or not.

12. The apparatus according to claim 11, wherein the power supply noise analysis module is configured to:
perform comparison on a communication quality parameter corresponding to the first noise situation of the subscriber line, and a communication quality parameter corresponding to the second noise situation of the subscriber line, and/or a communication quality parameter corresponding to the third noise situation of the subscriber line, and analyze whether the power supply noise emanates from the RPF and causes the communication quality parameter of the reverse power feed line to exceed a preset threshold or not.

13. The apparatus according to claim 11 or 12, wherein the power supply noise analysis module is further configured to: when the power supply noise emanates from the RPF and affects the subscriber line, determine a location and a cause of the power supply noise emanating from the RPF.

14. The apparatus according to claim 11, further comprising a power supply noise processing module, which is configured to: when the power supply noise emanates from the RPF and affects the subscriber line,
trigger a detection de-electrification function module to stop supplying power through an RPF line and/or set the RPF line to a low-power state; or
trigger a power supply control interface module to control a power supply control module to stop supplying power through an RPF line and/or set the RPF line to a low-power state; or
trigger a switch control module to stop supplying power through an RPF line and/or set the RPF line to a low-power state.

15. The apparatus according to claim 13, wherein the power supply noise analysis module is configured to determine that a failure occurs in an RPF device of the DPU or an RPF device of the user terminal to cause the power supply noise to affect the subscriber line.

16. The apparatus according to claim 11 or 12, wherein the power supply noise detection module is configured to:
detect a communication quality parameter of the subscriber line when there is no RPF, detect a communication quality parameter of the subscriber line when the power feed line of the PSE of the user terminal is connected to the PE and the PSU of the DPU and the PSE supplies power, and detect a communication quality parameter of the subscriber line when the PSE of the user terminal is disconnected from the PE and the PSU of the DPU and keeps the state of supplying power.

17. The apparatus according to claim 13, further comprising a detection switch control module;
wherein the power supply noise detection module is configured to: when there is no RPF, detect a communication quality parameter corresponding to the first noise situation of the subscriber line;
the power supply noise analysis module is configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to a detection electrification function module;
the power supply noise detection module is further configured to detect a communication quality parameter corresponding to the third noise situation of the subscriber line;
the power supply noise analysis module is further configured to: when the communication quality parameter corresponding to the third noise situation of the subscriber line exceeds a third preset parameter threshold, determine that a failure occurs in an RPF device of the user terminal to cause the power supply noise to affect the subscriber line; and when the communication quality parameter corresponding to the third noise situation of the subscriber line does not exceed the third preset parameter threshold, trigger the detection switch control module to disconnect the PSE from the detection electrification function module and connect the power feed line of the PSE to the PE and the PSU of the DPU;
the power supply noise detection module is further configured to: detect a communication quality parameter corresponding to the second noise situation of the subscriber line; and
the power supply noise analysis module is further configured to: when the communication quality parameter corresponding to the second noise situation of the subscriber line exceeds a second preset parameter threshold, determine that a failure occurs in an RPF device of the DPU to cause the power supply noise to affect the subscriber line;
or,
wherein the detection switch control module is configured to connect the power feed line of the PSE to the PE and the PSU of the DPU;
the power supply noise detection module is configured to detect a communication quality parameter corresponding to the second noise situation of the subscriber line;
the power supply noise analysis module is configured to: when the communication quality parameter corresponding to the second noise situation of the subscriber line exceeds a second preset parameter threshold, trigger a detection de-electrification function module to stop supplying power through the power feed line or trigger a power supply control interface module to control a power supply control module to stop supplying power through the power feed line;
the power supply noise detection module is further configured to detect a communication quality parameter corresponding to the first noise situation of the subscriber line;
the power supply noise analysis module is further configured to: when the communication quality parameter corresponding to the first noise situation of the subscriber line exceeds a first preset parameter threshold, determine that a failure occurs in the subscriber line when there is no RPF; and when the communication quality parameter corresponding to the first noise situation of the subscriber line does not exceed the first preset parameter threshold, trigger the detection switch control module to enable the PSE to supply power and connect the PSE to the detection electrification function module;
the power supply noise detection module is further configured to detect a communication quality parameter corresponding to the third noise situation of the subscriber line; and
the power supply noise analysis module is further configured to: when a communication quality parameter corresponding to the third noise situation of the subscriber line exceeds a third preset parameter threshold, determine that a failure occurs in an RPF device of the user terminal to cause the power supply noise to affect the subscriber line, and when the communication quality parameter corresponding to the third noise situation of the subscriber line does not exceed the third preset parameter threshold, determine that a failure occurs in an RPF device of the DPU to cause the power supply noise to affect the subscriber line.

18. The apparatus according to claim 13, wherein the power supply noise analysis module is configured to:
when it is detected that the communication quality parameter corresponding to the first noise situation of the subscriber line exceeds a first preset parameter threshold, determine that a failure occurs in the subscriber line when there is no RPF;
when it is detected that the communication quality parameter corresponding to the first noise situation of the subscriber line does not exceed the first preset parameter threshold and a communication quality parameter corresponding to the second noise situation of the subscriber line exceeds a second preset parameter threshold, determine that the power supply noise emanates from the RPF and affects the subscriber line;
when it is detected that the communication quality parameter corresponding to the first noise situation of the subscriber line does not exceed the first preset parameter threshold and a communication quality parameter corresponding to the third noise situation of the subscriber line exceeds a third preset parameter threshold, determine that the power supply noise emanates from the RPF and affects the subscriber line and determine that a failure occurs in an RPF device of the user terminal to cause the power supply noise; and
when it is detected that the communication quality parameter corresponding to the first noise situation of the subscriber line does not exceed the first preset parameter threshold, the communication quality parameter corresponding to the second noise situation of the subscriber line exceeds the second preset parameter threshold and the communication quality parameter corresponding to the third noise situation of the subscriber line does not exceed the third preset parameter threshold, determine that the power supply noise emanates from the RPF and affects the subscriber line and determine that a failure occurs in an RPF device of the DPU to cause a power supply noise.

19. The apparatus according to claim 13, wherein the power supply noise processing module is further configured to report the location and the cause of the power supply noise emanating from the RPF to a network management system.
